# EUROPEAN PATENT APPLICATION

(11) **EP 4 664 767 A1**
(43) Date of publication of application: **17.12.2025**
(21) Application number: 24752821.9
(22) Date of filing: 04.02.2024
(51) Int. Cl.: H04B 1/04

(54) **TRANSMITTING FRONT-END MODULE INTEGRATED WITH MULTIFUNCTIONAL POWER SUPPLY AND COMMUNICATION TERMINAL**

(30) Priority: 06.02.2023 CN 202310069202
(71) Applicant: Vanchip (Tianjin) Technology Co. Ltd, Tianjin 300457 (CN)
(72) Inventor: LU, Xianwei, Tianjin 300457 (CN); WANG, Feng, Tianjin 300457 (CN)
(74) Representative: Wang, Bo
(86) International application number: PCT/CN2024/075675
(87) International publication number: WO 2024/164966

(57) **Abstract**

Disclosed in the present invention are a transmitting front-end module integrated with a multifunctional power supply and a communication terminal. The transmitting front-end module comprises a logic control and power management chip, at least one power amplifier chip, an output switch chip, and a filter bank, wherein an input end of the logic control and power supply management chip is at least respectively connected to an MIPI control port and a battery voltage port, receives, through the battery voltage port, power supplied by an external battery assembly, and receives a first control signal from a baseband through the MIPI control port, so that the state of an output voltage and a path are controlled to supply power to the power amplifier chip or an external linear power amplifier module, and the working states of the power amplifier chip and the output switch chip are controlled. According to the transmitting front-end module, by using the technical solution of integrating time division multiplexing of the power supply chip and optimization, reliable power supply is ensured, external power supply chips are reduced, the hardware cost is reduced, and the occupied PCB layout area is reduced.

## Description

### BACKGROUND

### Technical Field

The present invention relates to the technical field of radio frequency integrated circuits, and provides a transmitting front-end module integrated with a multifunctional power supply, and further provides a radio frequency front-end and a communication terminal including the transmitting front-end module.

### Related Art

With development of a communication system, a communication terminal needs to be provided with a more complex and flexible radio frequency front-end, which needs to cover standards of 5G, 4G, 3G, and 2G, and needs to support high-end demands such as 5G + 4G dual connectivity (E-UTRAN new radio-dual connectivity (ENDC)), 5G dual transmission (2T multiple-input multiple-output (MIMO)), and 4G dual-frequency uplink carrier aggregation (dual-frequency ULCA). Therefore, the radio frequency front-end necessarily requires a plurality of high-power radio frequency devices such as a power amplifier and a plurality of channel power supplies. High efficiency and stability of a power supply circuit are vital to the performance of the radio frequency front-end.

In the prior art, a radio frequency architecture of a communication terminal generally requires at least two power supplies. A power supply chip, as an independent module, is usually provided by terminal device manufacturers. The power supply chip includes two external dual power supply chips (a direct current to direct current (DC-DC) converter), which cooperate with a power management integrated circuit (PMIC) of the device, to provide a combined power supply to satisfy a demand of the radio frequency architecture of the terminal for a plurality of power supplies. The power supply solution has at least the following disadvantages: 1. High hardware costs for the external power supply chip, especially for a boost DC-DC converter; 2. Relatively large printed circuit board (PCB) area occupation required for the external power supply chip. Therefore, terminal design manufacturers generally hope to optimize a power supply design to reduce occupation of a PCB area while minimizing hardware costs.

### SUMMARY

A primary technical problem to be resolved in the present invention is to provide a transmitting front-end module integrated with a multifunctional power supply.

Another technical problem to be resolved in the present invention is to provide a radio frequency front-end and a communication terminal including the transmitting front-end module.

To achieve the above objectives, the present invention adopts the following technical solutions:
According to a first aspect of the embodiments of the present invention, a transmitting front-end module integrated with a multifunctional power supply is provided, including at least one power amplifier chip, a logic control and power supply management chip, an output switch chip, and a filter bank, wherein
an input terminal of the power amplifier chip is connected to at least one radio frequency signal input port and is configured to amplify a radio frequency input signal from outside, and the amplified radio frequency signal is filtered by the filter bank and then outputted to the output switch chip;
the output switch chip is connected to a plurality of radio frequency signal switching ports and is configured to switch a path and couple a radio frequency signal inputted from one of the radio frequency signal switching ports to an antenna port; and
an input terminal of the logic control and power supply management chip is connected to at least a mobile industry processor interface (MIPI) control port and a battery voltage port respectively, and the input terminal receives a power supply from an external battery assembly through the battery voltage port, and receives a first control signal from a baseband through the MIPI control port, to control a state of an output voltage, so as to provide a power supply to the internal power amplifier chip or an external linear power amplifier module.

Preferably, the power amplifier chip is at least configured as a 2G power amplifier, and includes a 2G low-frequency power amplifier and a 2G intermediate-frequency power amplifier.

Preferably, the logic control and power supply management chip includes a low dropout regulator (LDO) unit, a direct current to direct current (DC-DC) unit, and a control unit;
the LDO unit is a linear regulated power supply, an input terminal thereof is connected to the battery voltage port and a ramp control voltage port respectively, and an output terminal thereof is connected to the power amplifier chip;
the DC-DC unit includes a buck DC power supply converter and a boost DC power supply converter, or is a buck-boost DC power supply converter, an input terminal thereof is connected to the battery voltage port, and an output terminal thereof is connected to a power supply output port; and
an input terminal of the control unit is connected to the MIPI control port, and is configured to receive and decode the first control signal from the baseband, control operating states of the internal LDO unit and the DC-DC unit, and control operating states of the external power amplifier chip and the output switch chip.

Preferably, the logic control and power supply management chip further includes a comprehensive unit, and the comprehensive unit is a comprehensive circuit unit having functions of temperature compensation, voltage compensation, over-current protection, and over-voltage protection.

Preferably, in a 2G communication mode, the logic control and power supply management chip is switched so that the LDO unit supplies power to the power amplifier chip; and in a non-2G communication mode, the logic control and power supply management chip is switched so that the DC-DC unit supplies power to at least one external linear power amplifier module through the power supply output port.

Preferably, when the LDO unit supplies power to the power amplifier chip, after the LDO unit performs voltage regulation on an inputted battery voltage, an output voltage supplies power to the power amplifier chip, and a magnitude of the output voltage depends on a second control signal inputted from the ramp control voltage port.

Preferably, when the DC-DC unit supplies power to the external linear power amplifier module, the DC-DC unit supplies power to the at least one external linear power amplifier module after preforming boost or buck processing on a battery voltage based on the first control signal; when an operating voltage of the linear power amplifier module is lower than the battery voltage, the DC-DC unit operates in a DC buck conversion mode; and when the operating voltage of the linear power amplifier module is higher than the battery voltage, the DC-DC unit operates in a DC boost conversion mode.

Preferably, the linear power amplifier module includes a low-frequency power amplifier, an intermediate-frequency power amplifier, a high-frequency power amplifier chip, or an ultra-high-frequency power amplifier chip, and is configured to support 3G, 4G, and/or 5G communication modes.

Preferably, in a 2G communication mode, the control unit controls the 2G low-frequency power amplifier and the 2G intermediate-frequency power amplifier of the power amplifier chip, where one of the amplifiers is enabled, and the other amplifier is disabled; and controls a corresponding path of the output switch chip to be turned on and other paths to be turned off, and couples an amplified 2G radio frequency signal to an antenna terminal.

Preferably, in a non-2G communication mode, the control unit controls the 2G low-frequency power amplifier and the 2G intermediate-frequency power amplifier of the power amplifier chip to be both disabled; and controls a corresponding path of the output switch chip to be turned on and other paths to be turned off, and couples a non-2G radio frequency signal amplified by the external linear power amplifier module to the antenna terminal.

Preferably, the logic control and power supply management chip is a complementary metal-oxide-semiconductor transistor (CMOS) chip.

According to a second aspect of the embodiments of the present invention, a radio frequency front-end is provided, which includes the foregoing transmitting front-end module integrated with a multifunctional power supply, and further includes at least one linear power amplifier module, a power management integrated circuit (PMIC) module, and a battery assembly.

According to a third aspect of the embodiments of the present invention, a communication terminal is provided, which includes the foregoing transmitting front-end module integrated with a multifunctional power supply.

Compared with the prior art, the transmitting front-end module integrated with a multifunctional power supply provided in the present invention adopts a technical solution with time-based reuse and optimized integration, which ensures a reliable power supply while reducing external power supply chips, and can achieve a compatible design at a board level. Therefore, the transmitting front-end module integrated with a multifunctional power supply provided in the present invention has beneficial effects such as a good and proper structural design, relatively low costs, high operating efficiency, and reduced occupation of a PCB area.

### BRIEF DESCRIPTION OF THE DRAWINGS

FIG. 1 is a schematic structural diagram of a power supply solution of a radio frequency front-end in the prior art.
FIG. 2 is a schematic structural diagram of the transmitting front-end module integrated with a multifunctional power supply according to the present invention.
FIG. 3 is a schematic structural diagram of a supply solution of a radio frequency front-end power according to the present invention.
FIG. 4 is a schematic structural diagram of a logic control and power supply management chip according to an embodiment of the present invention.
FIG. 5 is a schematic structural diagram of a power supply solution of the radio frequency front-end when operating in a 2G transmission scenario according to an embodiment of the present invention.
FIG. 6 is a schematic structural diagram of a power supply solution of the radio frequency front-end when operating in a 4G + 5G E-UTRAN new radio-dual connectivity (ENDC) transmission scenario according to an embodiment of the present invention.
FIG. 7 is a schematic structural diagram of a power supply solution of the radio frequency front-end when operating in a 5G dual transmission (2T multiple-input multiple-output (MIMO)) scenario according to an embodiment of the present invention.
FIG. 8 is a schematic structural diagram of a power supply solution of the radio frequency front-end when operating in a 4G dual-frequency uplink carrier aggregation (dual-frequency ULCA) transmission according to an embodiment of the present invention.
FIG. 9 is a schematic structural diagram of a power supply solution of the radio frequency front-end when operating in a 5G standalone (SA) low-voltage low-cost transmission according to an embodiment of the present invention.
FIG. 10 is a schematic structural diagram of a power supply solution of the radio frequency front-end when operating in a scenario with a power combining power amplifier according to an embodiment of the present invention.
FIG. 11 is a schematic diagram of a communication terminal adopting the transmitting front-end module integrated with a multifunctional power supply according to the present invention.

### DETAILED DESCRIPTION

Technical content of the present invention is described in detail below with reference to drawings and specific embodiments.

For convenience of comprehension and description, the present invention first provides a brief description of a power supply solution of a radio frequency front-end in the prior art, and describes specific technical solutions of the embodiments of the present invention in detail based on it.

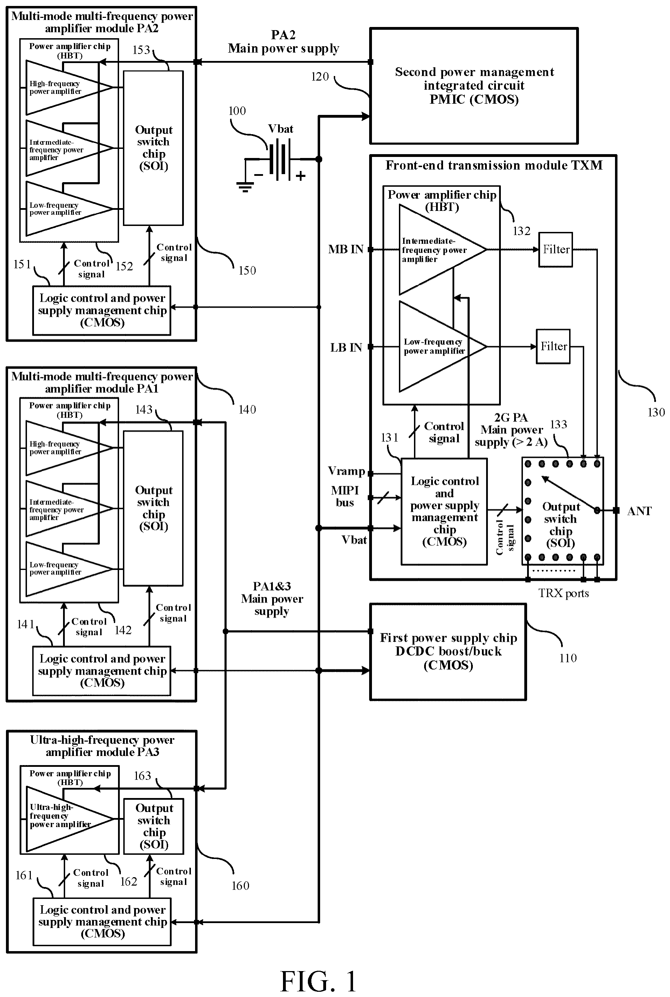

As shown in FIG. 1, in the prior art, a radio frequency front-end typically includes a battery assembly 100, a first power supply chip (direct current to direct current (DC-DC)) 110, a second power management integrated circuit (PMIC) 120, a transmitting front-end module (TXM) 130, a first multi-mode multi-frequency power amplifier module (PA1) 140, a second multi-mode multi-frequency power amplifier module (PA2) 150, and a third ultra-high-frequency power amplifier module (PA3) 160. The first multi-mode multi-frequency power amplifier module (PA1) 140, the second multi-mode multi-frequency power amplifier module (PA2) 150, and the third ultra-high-frequency power amplifier module (PA3) 160 are linear power amplifier modules. The battery assembly 100 is a general power supply for supplying power, which provides a power supply to the foregoing three linear power amplifier modules and the transmitting front-end module (TXM) 130 respectively directly or indirectly through the first power supply chip 110 and the second PMIC 120. A specific power supply solution is as follows:

First, the battery assembly 100 provides a power supply to the first power supply chip 110 and the second PMIC 120. Boost or buck processing is performed on a battery voltage Vbat through a DC-DC function inside the first power supply chip 110 and the second PMIC 120, and then the battery voltage provides a power supply to a power amplifier chip subassembly 142, a power amplifier chip subassembly 152, and a power amplifier chip subassembly 162 of the first multi-mode multi-frequency power amplifier module (PA1) 140, the second multi-mode multi-frequency power amplifier module (PA2) 150, and the third ultra-high-frequency power amplifier module (PA3) 160 respectively.

For different power supply voltages demands of the power amplifier chip subassembly 142, the power amplifier chip subassembly 152, and the power amplifier chip subassembly 162, the first power supply chip 110 and the second PMIC 120 may select a boost or buck DC-DC converter to provide a power supply. Typically, the battery voltage Vbat is about 3.8 V. For a voltage demand (e.g., 3.4 V) lower than the battery voltage Vbat, the buck DC-DC converter is used for a power supply. For a demand (e.g., 5.0 V) higher than the battery voltage Vbat, the boost DC-DC converter is used for a power supply.

Second, the battery assembly 100 directly provides a power supply to a logic control and power supply management chip subassembly 141, a logic control and power supply management chip subassembly 151, and a logic control and power supply management chip subassembly 161 of the first multi-mode multi-frequency power amplifier module (PA1) 140, the second multi-mode multi-frequency power amplifier module (PA2) 150, and the third ultra-high-frequency power amplifier module (PA3) 160.

Third, the battery assembly 100 directly provides a power supply to the transmitting front-end module (TXM) 130. The battery voltage Vbat, after voltage regulation (LDO) through the logic control and power supply management chip 131, supplies power to a power amplifier chip subassembly 132. A magnitude of a power supply voltage depends on an inputted ramp control voltage Vramp. The logic control and power supply management chip subassembly 131 is further responsible for processing a control instruction of an external mobile industry processor interface (MIPI) bus interface, and then providing a control signal to the internal power amplifier chip subassembly 132 and an output switch chip subassembly 133.

The foregoing power supply solution includes the following disadvantages: 1. High hardware costs for an external power supply chip, especially for a boost DC-DC converter; 2. Relatively large printed circuit board (PCB) area occupation required for the external power supply chip. To solve the foregoing problems in the prior art, the present invention provides a transmitting front-end module integrated with a multifunctional power supply based on the foregoing radio frequency front-end architecture, to solve the problems of high costs and relatively large occupation of a PCB area.

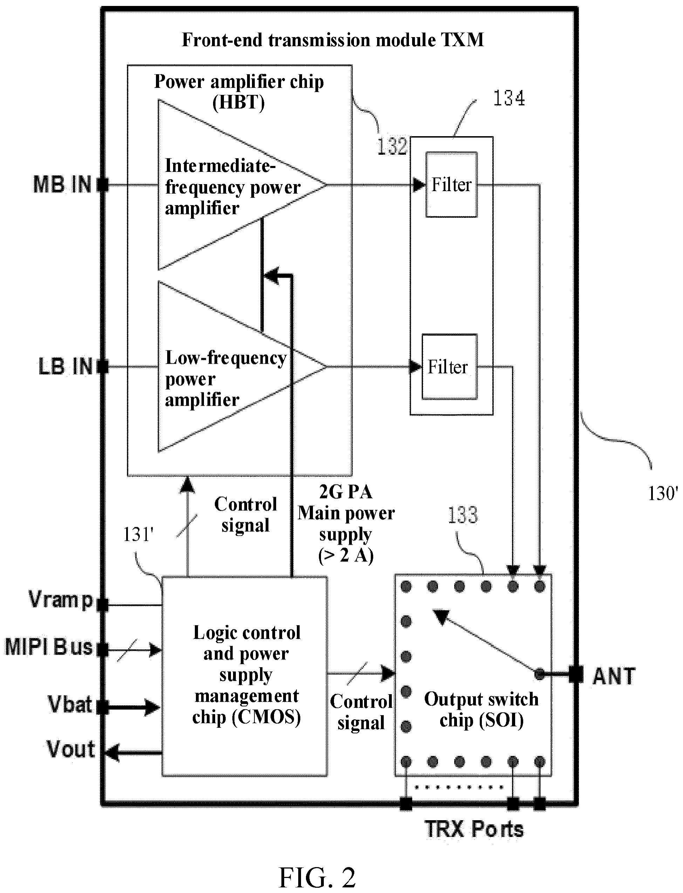

As shown in FIG. 2, a transmitting front-end module 130' integrated with a multifunctional power supply provided in an embodiment of the present invention includes a logic control and power supply management chip 131', at least one power amplifier chip 132, an output switch chip 133, and a filter bank 134, and further includes an MIPI control port, a ramp control voltage Vramp, a battery voltage Vbat, an output power supply Vout, at least one antenna port ANT, at least one radio frequency input signal (midband (MB) or low band (LB)) port, and a plurality of radio frequency signal switching ports TRX.

An input terminal of the logic control and power supply management chip 131' is connected to the MIPI control port, the ramp control voltage Vramp, and the battery voltage Vbat respectively. The input terminal receives a power supply from an external battery assembly through the battery voltage Vbat; and receives a first control signal from a baseband through the MIPI control port, to control a state of an output voltage of the logic control and power supply management chip 131'; and supplies power to the internal power amplifier chip subassembly 132 in a 2G mode, or supplies power to at least one external linear power amplifier module through the output power supply Vout in a non-2G (3G, 4G, or 5G) mode. When the internal power amplifier chip subassembly 132 supplies power, a power supply voltage depends on a magnitude of its power supply voltage is determined by a second control signal inputted from the ramp control voltage Vramp. In addition, the logic control and power supply management chip 131', after receiving the first control signal from the baseband through the MIPI control port, generates an internal control signal, and provides the internal control signal to the internal power amplifier chip 132 and the output switch chip subassembly 133.

An input terminal of the power amplifier chip 132 is connected to at least one radio frequency signal input port, and is configured to amplify a radio frequency input signal from outside in the 2G mode. The amplified radio frequency signal is filtered by the filter bank 134 and then outputted to the antenna port ANT through a corresponding path of the output switch chip 133. The power amplifier chip 132 may be at least configured as a 2G power amplifier.

The output switch chip 133 is connected to a plurality of radio frequency signal switching ports TRX, which switch to different signal paths to connect to the antenna port ANT based on the internal control signal. The output switch chip 133 transmits the output radio frequency signal of the internal power amplifier chip subassembly 132 to the antenna port ANT in the 2G mode, or transmits an output signal of the external linear power amplifier module to the antenna port ANT in the non-2G (3G, 4G, or 5G) mode.

Different from the transmitting front-end module 130 in the prior art, the logic control and power supply management chip subassembly 131' of the transmitting front-end module 130' provided in the embodiments of the present invention has a function of providing different power supply outputs in a plurality of scenarios.

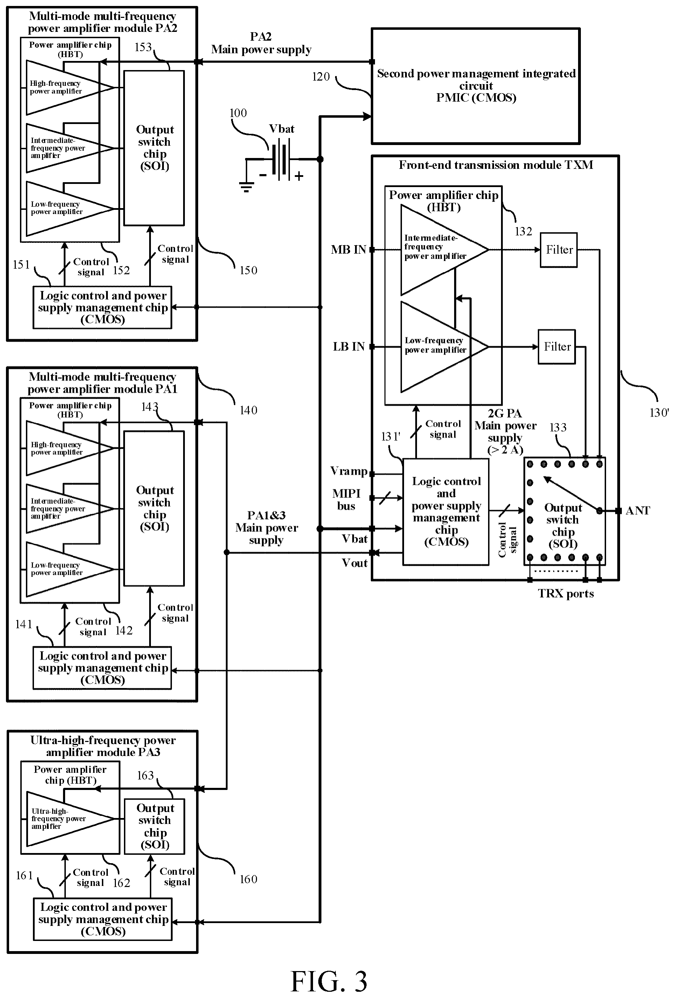

A power supply solution of a radio frequency front-end adopting the transmitting front-end module 130' provided in the embodiments of the present invention is shown in FIG. 3. The radio frequency front-end includes a battery assembly 100, a second PMIC 120, a transmitting front-end module (TXM) 130', a first multi-mode multi-frequency power amplifier module (PA1) 140, a second multi-mode multi-frequency power amplifier module (PA2) 150, and a third ultra-high-frequency power amplifier module (PA3) 160. The power amplifier chip 132 in the transmitting front-end module (TXM) 130' includes a 2G low-frequency power amplifier chip and a 2G intermediate-frequency power amplifier chip. The first multi-mode multi-frequency power amplifier module (PA1) 140, the second multi-mode multi-frequency power amplifier module (PA2) 150, and the third ultra-high-frequency power amplifier module (PA3) 160 are linear power amplifier modules, and include low-frequency, intermediate-frequency, high-frequency, or ultra-high-frequency power amplifier chips, and can support 3G, 4G, and/or 5G communication modes.

The battery assembly 100 is a general power supply. A specific power supply solution is as follows:
First, the battery assembly 100 provides a power supply to the second PMIC 120. Boost or buck processing is performed on a battery voltage Vbat through a DC-DC function inside the second PMIC 120, and then the battery voltage provides a power supply to the power amplifier chip subassembly 152 in the second multi-mode multi-frequency power amplifier module (PA2) 150.
Second, the battery assembly 100 directly provides a power supply to a logic control and power supply management chip subassembly 141, a logic control and power supply management chip subassembly 151, and a logic control and power supply management chip subassembly 161 of the first multi-mode multi-frequency power amplifier module (PA1) 140, the second multi-mode multi-frequency power amplifier module (PA2) 150, and the third ultra-high-frequency power amplifier module (PA3) 160.
Third, the battery assembly 100 directly provides a power supply to the transmitting front-end module (TXM) 130'. The battery voltage Vbat is switched and controlled by the logic control and power supply management chip 131' and then provides a power supply to the internal power amplifier chip 132 in the 2G mode. When the radio frequency front-end switches from a 2G state to a 3G, 4G, or 5G operating state, the logic control and power supply management chip subassembly 131' switches to a power supply output mode, and provides a power supply to the power amplifier chip subassembly 142 and the power amplifier chip subassembly 162 of the external first multi-mode multi-frequency power amplifier module (PA1) 140 and third ultra-high-frequency power amplifier module (PA3) 160 respectively through the output power supply Vout.

Therefore, the logic control and power supply management chip subassembly 131' can be reused based on time, which is fully used as hardware. The logic control and power supply management chip can provide a power supply to one or more power amplifiers in a communication mode at any moment. Therefore, a phenomenon in the prior art that the transmitting front-end module 130 is idle in a non-2G mode is avoided, thereby omitting an external independent power supply chip and reducing a PCB area.

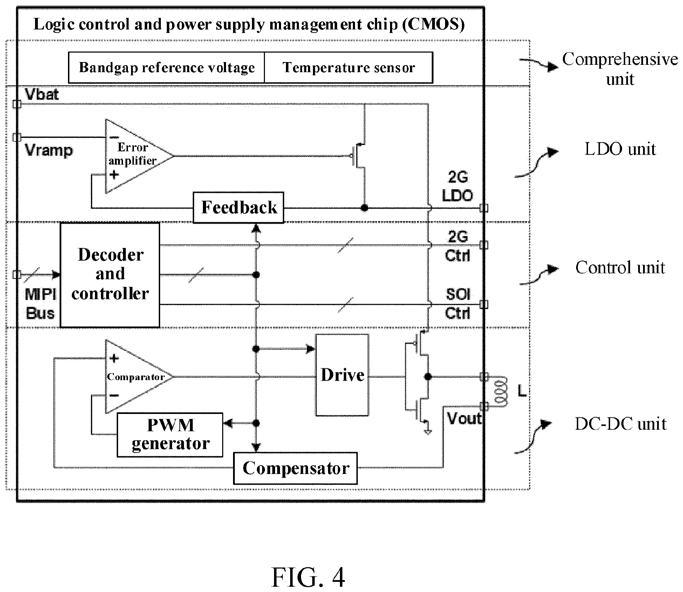

In an embodiment of the present invention, as shown in FIG. 4, the logic control and power supply management chip 131' includes a low dropout regulator (LDO) unit, a DC-DC unit, a control unit, and a comprehensive unit, and further includes an MIPI control port, a ramp control voltage Vramp, a battery voltage Vbat, an output power supply Vout, an LDO voltage output port, and an internal control signal output port. The LDO unit is a linear regulated power supply, an input terminal thereof is connected to the battery voltage Vbat and the ramp control voltage Vramp respectively, and an output terminal thereof is connected to the power amplifier chip 132. The DC-DC unit includes a buck DC power supply converter and a boost DC power supply converter, or is a buck-boost DC power supply converter, an input terminal thereof is connected to the battery voltage Vbat, and an output terminal thereof is connected to the output power supply Vout.

An input terminal of the control unit is connected to the MIPI control port, which receives and decodes a first control signal from a baseband, to control operating states of the LDO unit and the DC-DC unit, so that the LDO unit provides a supply power to the power amplifier chip subassembly 132 in the 2G mode, and the DC-DC unit supplies power to at least one external linear power amplifier module through the output power supply Vout in the non-2G (3G, 4G, or 5G) mode; and generates internal control signals, and provides control signals to the power amplifier chip 132 and the output switch chip 133 respectively through the internal control signal output port, to control operating states of the power amplifier chip 132 and the output switch chip 133.

When the logic control and power supply management chip 131' supplies power to the power amplifier chip 132 in the 2G mode, the LDO unit performs voltage regulation on the battery voltage Vbat inputted from a battery voltage port and the provides a power supply to the power amplifier chip 132 through the LDO voltage output port. A magnitude of an outputted power supply voltage depends on the ramp control voltage Vramp inputted from a ramp control voltage port. Moreover, the logic control and power supply management chip can provide a bias voltage to the power amplifier in the power amplifier chip 132. In this case, the logic control and power supply management chip 131' does not provide a power supply output to the outside.

When the logic control and power supply management chip 131' supplies power to the external linear power amplifier module in the non-2G (3G, 4G, or 5G) mode, the DC-DC unit performs, based on the first control signal, boost or buck processing on the battery voltage Vbat inputted from the battery voltage port, and then outputs a voltage to provide a power supply to at least one external linear power amplifier module through the output power supply Vout. In this case, the internal power amplifier of the logic control and power supply management chip 131' is disabled and does not require a power supply. Moreover, a power supply capability designed for the logic control and power supply management chip 131' can provide a sufficient current for subsequent low-voltage power amplifiers.

When an operating voltage of the external linear power amplifier module is lower than the battery voltage Vbat, the DC-DC unit operates in a DC buck conversion mode. When the operating voltage of the linear power amplifier module is higher than the battery voltage Vbat, the DC-DC unit operates in a DC boost conversion mode.

In the 2G communication mode, the internal control signal outputted from the control unit controls one of the low-frequency power amplifier and the intermediate-frequency power amplifier of the power amplifier chip 132 to be enabled and the other path to be disabled, and controls a corresponding path of the output switch chip 133 to be turned on and other paths to be turned off. The switch path that is turned on couples an amplified 2G radio frequency signal to the antenna terminal.

In the non-2G (3G, 4G, or 5G) mode, the internal control signal outputted from the control unit controls the low-frequency power amplifier and the intermediate-frequency power amplifier in the power amplifier chip 132 to be both disabled, and controls a corresponding path in the output switch chip 133 to be turned on and the other paths to be turned off. The switch path that is turned on couples a non-2G radio frequency signal amplified by the external linear power amplifier module to the antenna terminal.

The comprehensive unit is a comprehensive circuit unit having functions such as temperature compensation, voltage compensation, over-current protection, and over-voltage protection.

Because the logic control and power supply management chip 131' is an independent complementary metal-oxide-semiconductor transistor (CMOS) chip, the output power supply Vout may be implemented by an unused pin on an outside of the assembly, which helps achieve a design compatible with an existing solution at a PCB level compared to the logic control and power supply management chip 131 in the prior art. In addition, because the integration of the power supply chip is significantly improved, a board area occupied by the external power supply chip is reduced, and increase in dimensions of the transmitting front-end module is avoided, thereby avoiding a change in packaging of the original transmitting front-end module and physical dimensions of the pin.

An operating condition of the transmitting front-end module 130' integrated with a multifunctional power supply provided in the present invention is described below through specific application scenarios of the radio frequency front-end.

Application scenario 1: The radio frequency front-end operates in a 2G transmission scenario.

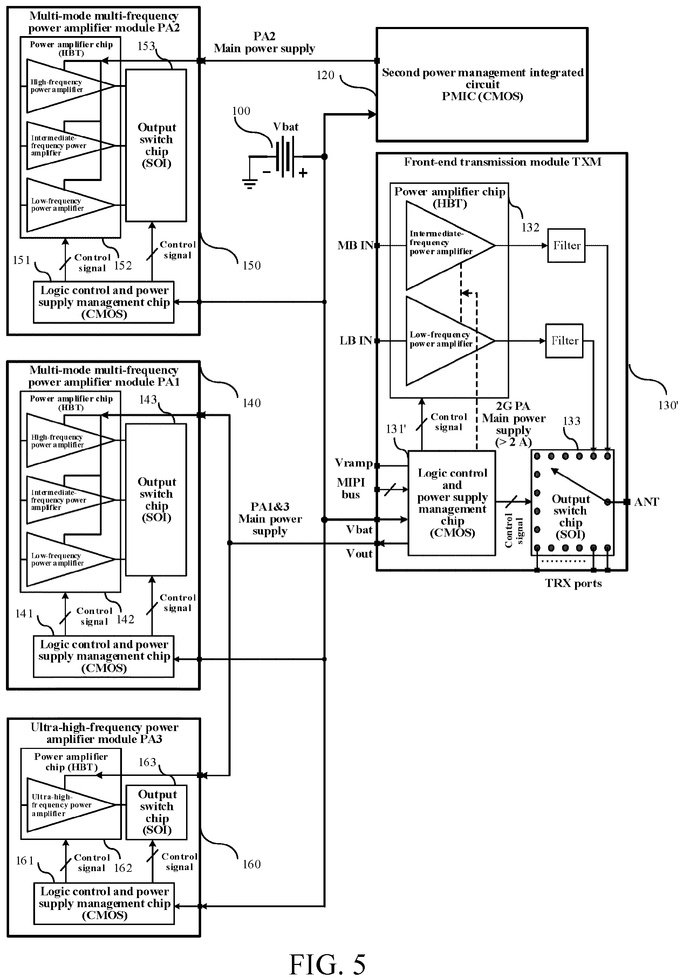

As shown in FIG. 5, in the 2G transmission scenario, based on the first control signal received through the MIPI control port, the logic control and power supply management chip subassembly 131' in the transmitting front-end module 130' operates in a linear regulated output (LDO) state, that is, the LDO unit operates, to provide a stable power supply with a voltage lower than the battery voltage Vbat and a current greater than 2 A to the internal 2G power amplifier chip subassembly 132, as indicated by the dashed lines in FIG. 5. In this case, the logic control and power supply management chip 131' does not provide a power supply to the outside, that is, the DC-DC unit does not operate. Moreover, the internal control signals generated by the logic control and power supply management chip 131' control the operating state of the power amplifier chip 132, and control the output switch chip 133 to couple an amplified 2G radio frequency signal to the antenna terminal through the path that is turned on.

Application scenario 2: The radio frequency front-end operates in a 4G + 5G E-UTRAN new radio-dual connectivity (ENDC) dual connectivity transmission scenario.

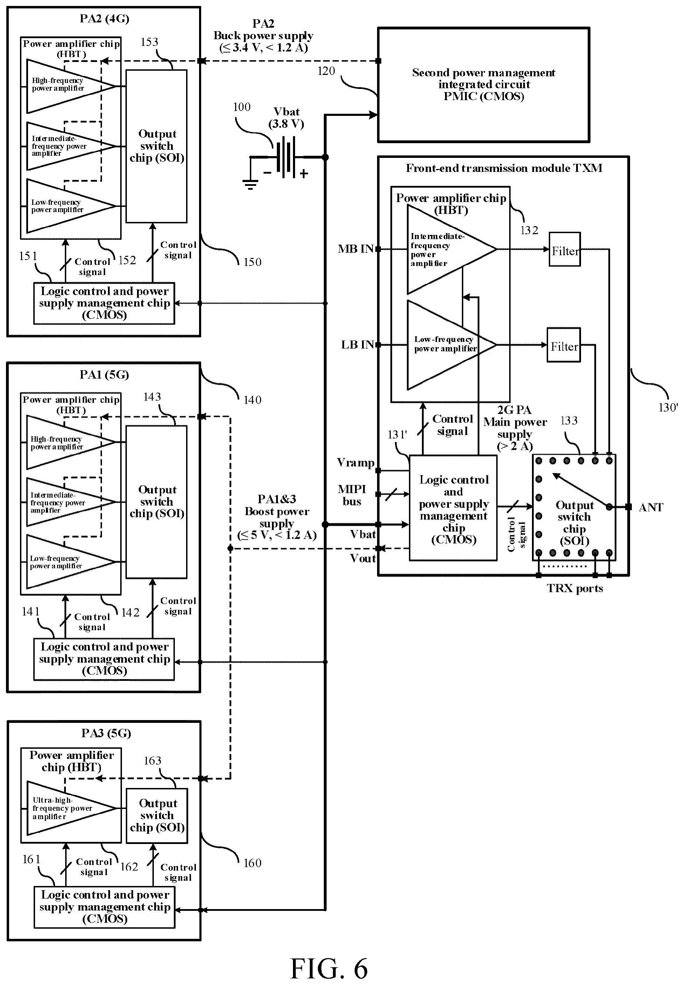

As shown in FIG. 6, because 5G typically requires a high-power linear output, in the 4G + 5G ENDC dual connectivity transmission scenario, a power supply voltage of the linear power amplifier module is usually designed as 4 V to 5 V which is higher than a battery voltage of 3.8 V, to achieve sufficient power and linearity. Therefore, the battery voltage needs boost processing. In this case, based on the first control signal received through the MIPI control port, the logic control and power supply management chip subassembly 131' in the transmitting front-end module 130' operates in a boost output state, that is, the DC-DC unit operates, to provide a power supply with a voltage less than or equal to 5 V and a current less than 1.2 A to a 5G linear power amplifier module through the output power supply Vout. Moreover, the PMIC built in the device provides a power supply with a voltage less than or equal to 3.4 V and a current less than 1.2 A to a 4G linear power amplifier module. In FIG. 6, for a combination of 4G + 5G, any 4G power amplifier may be combined with any 5G power amplifier.

Moreover, the internal control signals generated by the logic control and power supply management chip 131' control the power amplifier chip 132 to be disabled, and control the operating state of the output switch chip 133 to couple a 4G or 5G radio frequency signal amplified by the external linear power amplifier module to the antenna terminal through a path that is turned on.

Application scenario 3: The radio frequency front-end operates in a 5G dual transmission (2T multiple-input multiple-output (MIMO)) scenario.

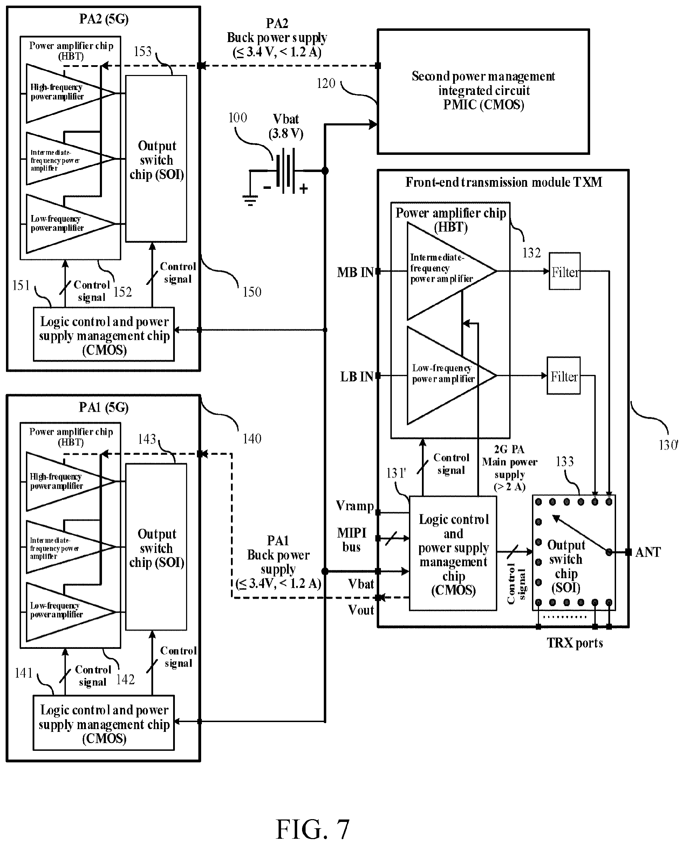

As shown in FIG. 7, in the 5G dual transmission scenario, although two 5G linear power amplifier modules need to operate simultaneously, a power of each module may be reduced by 50% to remain a total power constant. Therefore, a demand for a power supply voltage is not high. A power supply voltage of 3.4 V which is lower than the battery voltage of 3.8 V usually meets the demand. Therefore, the battery voltage needs buck processing. In this case, based on the first control signal received through the MIPI control port, the logic control and power supply management chip subassembly 131' in the transmitting front-end module 130' operates in a buck output state, that is, the DC-DC unit operates, to provide a power supply with a voltage less than or equal to 3.4V and a current less than 1.2 A to one of the 5G linear power amplifier modules through the output power supply Vout. Moreover, the PMIC built in the device provides a power supply with a voltage less than or equal to 3.4 V and a current less than 1.2 A to the other 5G linear power amplifier module. In FIG. 7, 5G dual transmission is exemplified as occurring in a high-frequency scenario, but scenarios such as ultra-high-frequency dual transmission is also allowed.

Moreover, the internal control signals generated by the logic control and power supply management chip 131' control the power amplifier chip 132 to be disabled, and control the operating state of the output switch chip 133 to couple a 5G radio frequency signal amplified by the external linear power amplifier module to the antenna terminal through a path that is turned on.

Application scenario 4: The radio frequency front-end operates in a 4G dual-frequency uplink carrier aggregation (dual-frequency ULCA) transmission scenario.

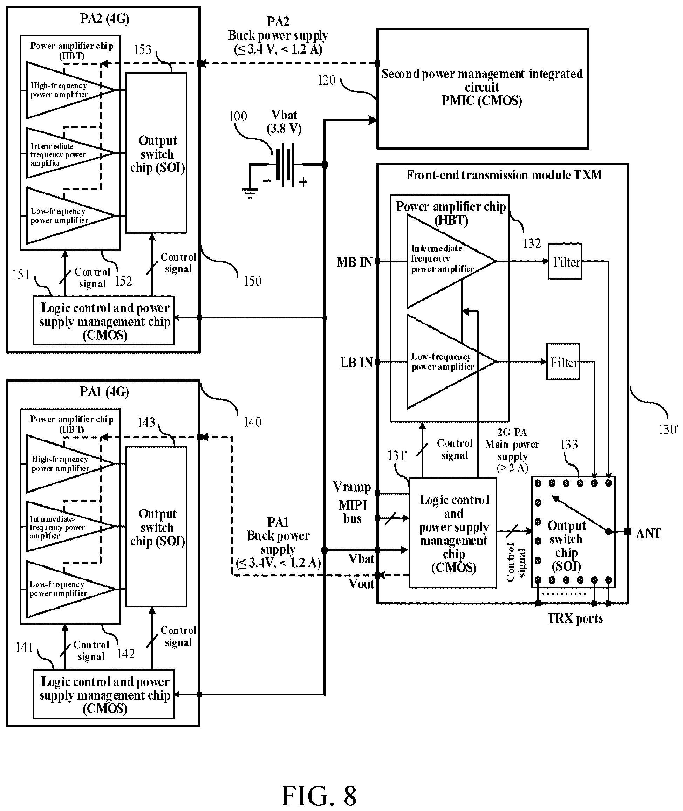

As shown in FIG. 8, in the 4G dual-frequency ULCA transmission scenario,
two 4G linear power amplifier modules operating simultaneously require a power supply voltage of 3.4 V, which is lower than the battery voltage of 3.8 V. Therefore, the battery voltage needs buck processing. In this case, based on the first control signal received through the MIPI control port, the logic control and power supply management chip subassembly 131' in the transmitting front-end module 130' operates in a buck output state, that is, the DC-DC unit operates, to provide a power supply with a voltage less than or equal to 3.4V and a current less than 1.2 A to one of the 4G linear power amplifier modules through the output power supply Vout. Moreover, the PMIC built in the device provides a power supply with a voltage less than or equal to 3.4 V and a current less than 1.2 A to the other 4G linear power amplifier module. In FIG. 8, for a combination of 4G dual-frequency ULCA, any of the two power amplifier modules may be selected for combination.

Moreover, the internal control signals generated by the logic control and power supply management chip 131' control the power amplifier chip 132 to be disabled, and control the operating state of the output switch chip 133 to couple a 4G radio frequency signal amplified by the external linear power amplifier module to the antenna terminal through a path that is turned on.

Application scenario 5: The radio frequency front-end operates in a 5G standalone (SA) low-voltage low-cost transmission scenario.

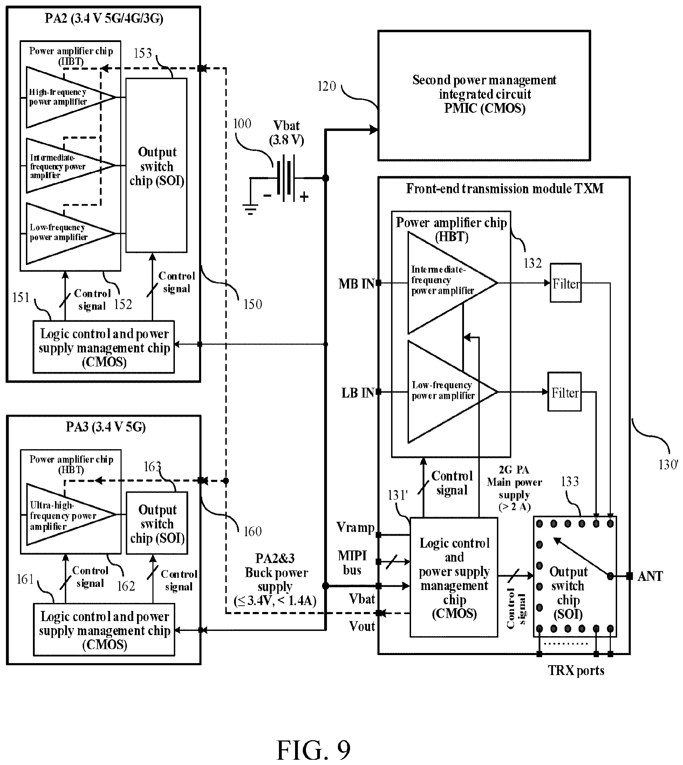

As shown in FIG. 9, in the 5G SA low-voltage low-cost transmission scenario, a power supply voltage of the linear power amplifier module is designed as a low voltage of 3.4 V, but a required current thereof exceeds the maximum output current of 1.2 A of the PMIC built in the device. In this case, based on the first control signal received through the MIPI control port, the logic control and power supply management chip subassembly 131' in the transmitting front-end module 130' operates in a buck output state, that is, the DC-DC unit operates, to provide a power supply with a voltage less than or equal to 3.4V and a current less than 1.4A to a 5G low-voltage linear power amplifier module through the output power supply Vout. In FIG. 9, in the 5G SA low-voltage low-cost transmission scenario, all linear power amplifier modules share one power supply.

Moreover, the internal control signals generated by the logic control and power supply management chip 131' control the power amplifier chip 132 to be disabled, and control the operating state of the output switch chip 133 to couple a 5G radio frequency signal amplified by the external linear power amplifier module to the antenna terminal through a path that is turned on.

Application scenario 6: The radio frequency front-end operates in a scenario with a power combining power amplifier.

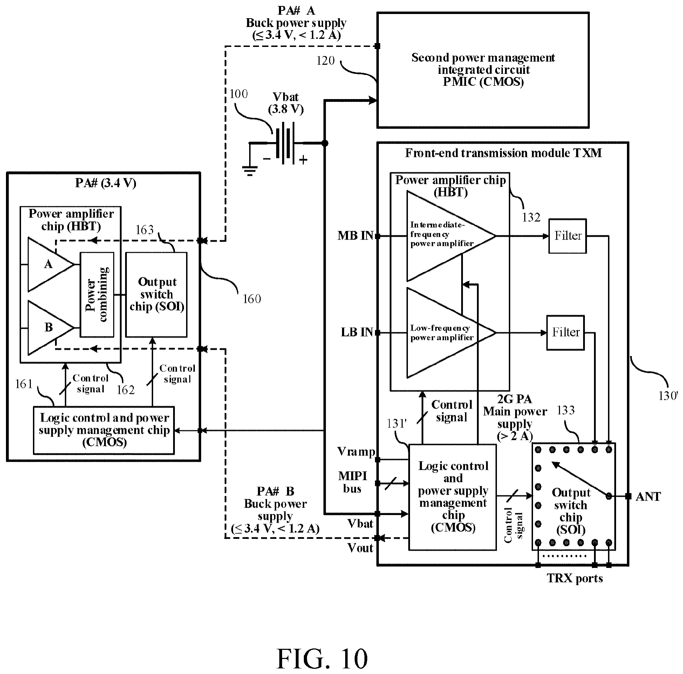

When the radio frequency front-end needs to provide a high power, a technical solution of power combining is frequently used. As shown in FIG. 10, in the scenario with a power combining power amplifier, if a single low-voltage power supply is used to provide a power supply for power combining power amplifier, a power supply current exceeds the upper limit of 1.2 A. Therefore, a technical solution using two separate power supply is required. In this case, the logic control and power supply management chip subassembly 131' in the transmitting front-end module 130' operates in a buck output state, that is, the DC-DC unit operates, to provide a power supply with a voltage less than or equal to 3.4V and a current less than 1.4A to a linear power amplifier module B through the output power supply Vout. Moreover, the PMIC built in the device provides a power supply with a voltage less than or equal to 3.4 V and a current less than 1.2 A to a linear power amplifier module A. In FIG. 10, power combining power amplifier module may be applied to various frequency bands, and may adopt a general power supply manner.

Based on the foregoing transmitting front-end module integrated with a multifunctional power supply, the embodiments of the present invention provide a radio frequency front-end, including the transmitting front-end module integrated with a multifunctional power supply, at least one linear power amplifier module, a power management integrated circuit (PMIC) module, and a battery assembly. The radio frequency front-end is used in a communication terminal of wireless communication systems to perform amplification and transmission of radio frequency signals. A specific structure of the transmitting front-end module integrated with a multifunctional power supply in the radio frequency front-end is not described in detail herein.

In addition, the transmitting front-end module integrated with a multifunctional power supply provided in the present invention may be further used in a communication terminal as an important component of a radio frequency assembly. The communication terminal mentioned herein refers to a communication device that may be used in a mobile environment and supports a plurality of communication modes such as GSM, EDGE, CDMA, TD_SCDMA, WCDMA, TDD_LTE, FDD_LTE, and NR. The communication device includes a mobile phone, a notebook computer, a tablet computer, an on-board computer, and the like. In addition, the technical solutions provided in the embodiments of the present invention are also applicable to applications of other radio frequency integrated circuits, such as a communication base station and an intelligent connected vehicle.

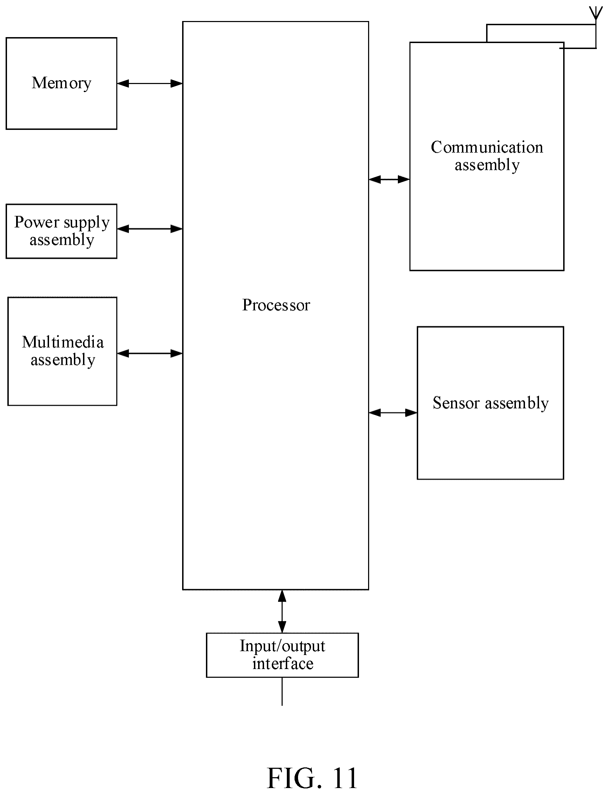

As shown in FIG. 11, the communication terminal includes at least a communication assembly, a processor, and a memory, and may further include a sensor assembly, a power supply assembly, a multimedia assembly, and an input/output (I/O) interface according to actual requirements. The memory, the communication assembly, the sensor assembly, the power supply assembly, the multimedia assembly, and the I/O interface are all connected to the processor. The memory may be a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, or the like. The processor may be a central processing unit (CPU), a graphics processing unit (GPU), a field-programmable gate array (FPGA), an application-specific integrated circuit (ASIC), a digital signal processing (DSP) chip, or the like. The communication assembly, the sensor assembly, the power supply assembly, the multimedia assembly, and the like may be implemented by using a general-purpose component. Details are not described herein.

In conclusion, compared with the prior art, the transmitting front-end module integrated with a multifunctional power supply provided in the present invention adopts a technical solution with time-based reuse of a power supply chip and optimized integration, which ensures a reliable power supply while reducing external power supply chips, and can achieve a compatible design at a board level. Therefore, the transmitting front-end module integrated with a multifunctional power supply provided in the present invention has beneficial effects such as a good and proper structural design, relatively low costs, high operating efficiency, and reduced occupation of a PCB area.

It should be noted that the foregoing embodiments are merely examples. The technical solutions of the embodiments may be combined with each other, all of which fall within the protection scope of the present invention. In addition, terms "first" and "second" are merely used for description, and cannot be understood as indicating or implying relative importance or implying a quantity of indicated technical features. Therefore, a feature defined with "first" or "second" may explicitly or implicitly include one or more features. In the description of the present invention, "a plurality of" means two or more, unless explicitly and specifically defined otherwise.

The transmitting front-end module integrated with a multifunctional power supply and the communication terminal provided in the present invention have been described in detail above. A person of ordinary skill in the art making any apparent change made to the present invention without departing from the essential content of the present invention constitutes infringement to the patent right of the present invention, and should bear a corresponding legal liability.

## Claims

1. A transmitting front-end module integrated with a multifunctional power supply, comprising at least one power amplifier chip, a logic control and power supply management chip, an output switch chip, and a filter bank, wherein
an input terminal of the power amplifier chip is connected to at least one radio frequency signal input port and is configured to amplify a radio frequency input signal from outside, and the amplified radio frequency signal is filtered by the filter bank and then outputted to the output switch chip;
the output switch chip is connected to a plurality of radio frequency signal switching ports and is configured to switch a path and couple a radio frequency signal inputted from one of the radio frequency signal switching ports to an antenna port; and
an input terminal of the logic control and power supply management chip is connected to at least a mobile industry processor interface (MIPI) control port and a battery voltage port respectively, and the input terminal receives a power supply from an external battery assembly through the battery voltage port, and receives a first control signal from a baseband through the MIPI control port, to control a state of an output voltage, so as to provide a power supply to the internal power amplifier chip or an external linear power amplifier module.

2. The transmitting front-end module integrated with a multifunctional power supply according to claim 1, wherein
the power amplifier chip is at least configured as a 2G power amplifier, and comprises a 2G low-frequency power amplifier and a 2G intermediate-frequency power amplifier.

3. The transmitting front-end module integrated with a multifunctional power supply according to claim 1, wherein
the logic control and power supply management chip comprises a low dropout regulator (LDO) unit, a direct current to direct current (DC-DC) unit, and a control unit;
the LDO unit is a linear regulated power supply, an input terminal thereof is connected to the battery voltage port and a ramp control voltage port respectively, and an output terminal thereof is connected to the power amplifier chip;
the DC-DC unit comprises a buck DC power supply converter and a boost DC power supply converter, or is a buck-boost DC power supply converter, an input terminal thereof is connected to the battery voltage port, and an output terminal thereof is connected to a power supply output port; and
an input terminal of the control unit is connected to the MIPI control port, and is configured to receive and decode the first control signal from the baseband, control operating states of the internal LDO unit and the DC-DC unit, and control operating states of the external power amplifier chip and the output switch chip.

4. The transmitting front-end module integrated with a multifunctional power supply according to claim 3, wherein
the logic control and power supply management chip further comprises a comprehensive unit, and the comprehensive unit is a comprehensive circuit unit having functions of temperature compensation, voltage compensation, over-current protection, and over-voltage protection.

5. The transmitting front-end module integrated with a multifunctional power supply according to claim 3, wherein
in a 2G communication mode, the logic control and power supply management chip is switched so that the LDO unit supplies power to the power amplifier chip; and in a non-2G communication mode, the logic control and power supply management chip is switched so that the DC-DC unit supplies power to at least one external linear power amplifier module through the power supply output port.

6. The transmitting front-end module integrated with a multifunctional power supply according to claim 5, wherein
when the LDO unit supplies power to the power amplifier chip, after the LDO unit performs voltage regulation on an inputted battery voltage, an output voltage supplies power to the power amplifier chip, and a magnitude of the output voltage depends on a second control signal inputted from the ramp control voltage port.

7. The transmitting front-end module integrated with a multifunctional power supply according to claim 5, wherein
when the DC-DC unit supplies power to the external linear power amplifier module, the DC-DC unit supplies power to the at least one external linear power amplifier module after preforming boost or buck processing on a battery voltage based on the first control signal; when an operating voltage of the linear power amplifier module is lower than the battery voltage, the DC-DC unit operates in a DC buck conversion mode; and when the operating voltage of the linear power amplifier module is higher than the battery voltage, the DC-DC unit operates in a DC boost conversion mode.

8. The transmitting front-end module integrated with a multifunctional power supply according to claim 5 or 7, wherein
the linear power amplifier module comprises a low-frequency power amplifier, an intermediate-frequency power amplifier, a high-frequency power amplifier chip, or an ultra-high-frequency power amplifier chip, and is configured to support 3G, 4G, and/or 5G communication modes.

9. The transmitting front-end module integrated with a multifunctional power supply according to claim 3, wherein
in a 2G communication mode, the control unit controls the 2G low-frequency power amplifier and the 2G intermediate-frequency power amplifier of the power amplifier chip, wherein one of the amplifiers is enabled, and the other amplifier is disabled; and controls a corresponding path of the output switch chip to be turned on and other paths to be turned off, and couples an amplified 2G radio frequency signal to an antenna terminal.

10. The transmitting front-end module integrated with a multifunctional power supply according to claim 3, wherein
in a non-2G communication mode, the control unit controls the 2G low-frequency power amplifier and the 2G intermediate-frequency power amplifier of the power amplifier chip to be both disabled; and controls a corresponding path of the output switch chip to be turned on and other paths to be turned off, and couples a non-2G radio frequency signal amplified by the external linear power amplifier module to the antenna terminal.

11. The transmitting front-end module integrated with a multifunctional power supply according to claim 1 or 3, wherein
the logic control and power supply management chip is a complementary metal-oxide-semiconductor transistor (CMOS) chip.

12. A radio frequency front-end, comprising the transmitting front-end module integrated with a multifunctional power supply according to any one of claims 1 to 11, and further comprising at least one linear power amplifier module, a power supply management chip module, and a battery assembly.

13. A communication terminal, comprising the transmitting front-end module integrated with a multifunctional power supply according to any one of claims 1 to 11.
